(19) Europäisches Patentamt
European Patent Office
Office européen des brevets

(11) **EP 1 359 469 B1**

(12) **EUROPEAN PATENT SPECIFICATION**

(45) Date of publication and mention
of the grant of the patent:
**02.03.2011 Bulletin 2011/09**

(51) Int Cl.:
***G03F 7/20*** *(2006.01)*     ***G03F 9/00*** *(2006.01)*
***H01L 21/00*** *(2006.01)*     ***H01L 21/68*** *(2006.01)*

(21) Application number: **03252747.5**

(22) Date of filing: **29.04.2003**

(54) **Chuck, lithographic projection apparatus and device manufacturing method**

Halter, lithographischer Projektionsapparat und Verfahren zur Herstellung einer Vorrichtung

Support, appareil de projection lithographique et méthode de fabrication d'un dispositif

(84) Designated Contracting States:
**DE FR GB IT NL**

(30) Priority: **01.05.2002 EP 02253073**

(43) Date of publication of application:
**05.11.2003 Bulletin 2003/45**

(73) Proprietor: **ASML Netherlands B.V.**
**5504 DR Veldhoven (NL)**

(72) Inventors:
• **van Elp, Jan**
**2613 RM Delft (NL)**

• **Giesen, Peter**
**2516 SH Den Haag (NL)**
• **van der Velde, Jacob Jan**
**2284 GN Rijswijk (NL)**

(74) Representative: **Slenders, Petrus J. W. et al**
**ASML Netherlands B.V**
**Corporate Intellectual Property**
**P.O. Box 324**
**5500 AH Veldhoven (NL)**

(56) References cited:
**EP-A- 1 191 581     US-A- 5 954 982**
**US-A1- 2002 044 267     US-B1- 6 368 942**

**Description**

The present invention relates to a chuck for use in holding onto a supporting table by electrostatic force:

- a substrate to be processed in manufacturing devices employing lithographic projection techniques; or
- a lithographic projection mask or mask blank in a lithographic projection apparatus, a mask handling apparatus such as a mask inspection or cleaning apparatus, or a mask manufacturing apparatus;

said chuck comprising:

a first dielectric member.

The present invention also relates to a lithographic projection apparatus comprising:

- a radiation system for supplying a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate.

The present invention also relates to a method of manufacturing a substrate, mirror or mask table or a chuck or a frame for a lithographic projection apparatus.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required.
- A programmable LCD array. An example of such a construction is given in United States Patent US 5,229,872. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus — commonly referred to as a step-and-scan apparatus — each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

In a lithographic apparatus, it is essential that the substrate be held very rigidly on the substrate table so that its position can be accurately known even when the substrate table undergoes high accelerations during its scanning motion. In existing machines, the substrate holder, or chuck, comprises a pimpled surface surrounded by a wall. The substrate rests on the wall and pimples and the space behind it is evacuated so that air pressure above provides a strong clamping force holding the substrate in place. Further details of such a substrate holder can be found in EP-A-0 947 884.

The above type of substrate holder has proven effective for present day lithographic apparatus. However, to meet the ever-present demand for imaging features of reduced size, it is necessary to reduce the wavelength of the radiation used for the projection beam. Thus, whilst current devices use ultraviolet radiation, *e.g.* with a wavelength of 248nm, 193nm or 157nm, improved resolution requires the development of lithographic apparatus making use of extreme ultraviolet (EUV) radiation (*i.e.* with a wavelength of less than about 50nm), x-rays, electrons or ions. These proposed types of radiation all share the requirement that the beam path, or at least substantial parts of it, must be kept in vacuum. Thus, without any air pressure above the substrate, the conventional vacuum-based substrate holder cannot function.

Similar requirements also need to be met in mask writing, mask cleaning and mask inspection apparatus and so chucks suffer from the same problems as the lithographic projection apparatus.

It has therefore been proposed to use electrostatic forces to hold the substrate onto the substrate table using an electrostatic chuck. To effect this, a potential difference is applied across a dielectric material with electrodes. In one example of such an electrostatic chuck (or clamp) a potential difference is applied between an electrode on the substrate and an electrode in or on the substrate table. When the potential difference is applied, the electrode of the substrate and the electrode of the table become oppositely charged and attract each other with sufficient force to clamp the substrate in place.

US 2002/0044267 discloses a holder which comprises a platen made of ULE (TM) on which a holder is positioned. The holder may be an electrostatic chuck as disclosed, for example, in US 5,221,403, US 5,835,333 or US 5,835,334.

US 6 368 942 discloses using anodic bonding to join a silicon wafer to an ULE wafer.

It has been found that the substrate can be difficult to remove from chuck even once the potential difference applied between the electrodes has been removed because an attractive force is still present. This can have a deleterious effect on productivity as it takes longer to load and unload substrates from their tables.

These problems are present when chucks are used for holding onto a supporting table a lithographic projection mask or mask blank in a lithographic projection apparatus, a mask handling apparatus such as a mask inspection or cleaning apparatus or a mask manufacturing apparatus. The chuck of the present invention may also be incorporated into any of those types of devices.

It is an object of the present invention to provide a clamp in which the substrate is easy to remove quickly after the potential difference applied between the electrodes has been removed and which has a low coefficient of thermal expansion so that unwanted variations in position due to thermal fluctuations are avoided.

This and other objects are achieved according to the invention in a chuck as specified in the opening paragraph, characterized in that said first dielectric member is made of a material which has a specific resistivity of at least $10^{16}$ $\Omega$cm and a coefficient of thermal expansion of less than $0.02 \times 10^{-6} \text{K}^{-1}$.

It has been found that by ensuring that the material of the dielectric member has a specific resistivity of at least $10^{16}$ $\Omega$ cm, the residual clamping force of a chuck, after the potential difference between electrodes has been removed, falls to an acceptable level within an acceptable time period. It is believed that this is because the clamping force of the chuck is a combination of a purely capacitive attraction between the charged electrodes and the forces resulting from the Johnson-Rahbek effect.

The Johnson-Rahbek effect depends on current leakage through the dielectric member between the electrodes. The force developed by the Johnson-Rahbek effect increases with time that the potential difference between the electrodes is present. Once the potential difference between the electrodes has been removed, the force due to the Johnson-Rahbek effect decreases with time at a rate determined by the conductivity of the dielectric member and the resistance of the dielectric material to wafer/mask interface.

By using a dielectric with a specific resistance of at least $10^{16}$ $\Omega$ cm it has been found that the clamping force due to the Johnson-Rahbek effect is kept to acceptable limits for typical time periods that the potential difference is applied between the electrodes in a lithographic projection apparatus.

The dielectric member must have good optical and mechanical properties, in that it can be polished to an extremely flat surface and that it has a low thermal expansion. This is because the substrate W is in direct contact with the first dielectric member. It has been found that ULE (TM), a glass (manufactured by Corning Incorporated, One Riverfront Plaza, Corning, NY 14831) meets all the necessary criteria.

Various different arrangements of electrostatic chuck are possible. These include an arrangement where the electrostatic chuck is essentially only a planar dielectric member and a first electrode is provided on the surface of the substrate in contact with the dielectric member and a second electrode is provided on the substrate table. However, more sophisticated electrostatic chucks are also possible including one where the first electrode and a second electrode are provided on a second surface of the dielectric member opposite a first surface and the first and second electrodes are in spaced apart relationship. In this way it is not necessary to ground the substrate. In this embodiment it is possible to make the electrostatic chuck separate from the substrate table such that it can easily be cleaned.

A separate electrostatic chuck is accomplished by the electrostatic chuck further comprising a core attached to the second side of the first dielectric member; a second dielectric member being attached to said core on a side opposite said first dielectric member and with a third electrode sandwiched between the core and the second dielectric member. In this case a further electrode is provided in or on the substrate table to interact with the third electrode to hold the electrostatic chuck to the substrate table.

In order to manufacture such a chuck it is necessary to attach the dielectric member and the core. The best materials for both of those parts of the electrostatic chuck are generally glasses or glass ceramics which have the required optical and mechanical properties (flatness and low thermal expansion). As discussed above, ULE (TM) is one of the preferred materials for the dielectric element. The core may be made of any low thermal expansion material, for example, Zerodur (TM) (manufactured by Schott Glas, Hattenbergstrasße 10 55120, Mainz, Germany). These materials are extremely difficult to join together. Gluing the two elements together is not an option as using glue is detrimental to the flatness of the first surface of the dielectric element because the Young's Modulus of glue is different to that of glass, or glass ceramic, and so if the glass ( or glass ceramic ) is thin and the glue thickness not uniform, stiffness variations over the surface result thereby leading to a reduction in the flatness achievable during polishing. Furthermore, use of glue can also introduce thermal expansion phenomena as the glue has too high a thermal expansion coefficient. Furthermore, glues degas strongly in vacuums. A bond made by gluing or physically bonding is not very strong if the first glass ( or glass ceramics ) member thickness is only a few tens of $\mu$m as that member will have lost its stiffness, which makes pealing of the thin layer possible. Physical bonding has also been tried but the bond created by such methods has been found not to be strong enough. It will be apparent that other parts of lithographic projection apparatus manufactured from glass or glass ceramics have similar problems.

Therefore, it is desirable to provide a method of bonding together a glass or a glass ceramic and a glass or a glass ceramic and in particular a glass element and a glass ceramics element, with an electrode between the elements, which produces a bond which does not distort the glass members but provides a strong bond between them.

This is achieved in a method of manufacturing members for optical applications including a substrate, mirror or mask table or a chuck or a frame for a lithographic projection apparatus comprising joining together a plurality of glass or glass ceramic members using anodic bonding, wherein at least one of said members has a coefficient of thermal expansion of less than $0.1 \times 10^{-6} K^{-1}$, preferably of less than $0.02 \times 10^{-6} K^{-1}$.

In particular the method may be used to manufacture a chuck, said method comprising the step of joining a glass member with a specific resistivity of at least $10^{16} \Omega$ cm to a glass ceramic member with an electrode sandwiched therebetween, said step of joining comprising the sub steps of:

coating said glass member in a metal;
placing said glass ceramics member in contact with said metal;
providing an electrode on said glass ceramics member on a surface opposite the surface in contact with said metal; and
applying a potential difference between said metal and said electrode thereby to drive an ion current between said metal and said electrode.

In this way it is possible to attach ULE (TM) to any isolator material (glass ceramic) having some conductivity (e.g. Zerodur (TM) or Clearceram (TM)) with an electrode therebetween which is the preferred arrangement of electrostatic chuck for a lithographic projection apparatus. Also, as to compared to gluing or soldering the conductive metal layer may be only a few hundred nm thick, so that it has less influence on the low thermal expansion characteristics of the chuck has a whole. Furthermore, no materials with strong degassing (such as glue) are needed to make the bond between the first and second glass elements.

Although the method has been described in relation to making a chuck, the method is applicable to attaching different pieces of glass ceramic for other purposes such as manufacturing substrate or mask tables or mirrors for use in lithographic projection apparatus. Using this method complicated glass structures can easily be made from different glass parts which will not result in degassing under vacuum and will result in a structure with very low thermal expansion characteristics.

According to a further aspect of the invention there is provided a device manufacturing method comprising the steps of:

- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material,
- providing an electrostatic chuck for holding said substrate to said substrate table, said electrostatic chuck comprising a first dielectric member;
- positioning said substrate on a first surface of said first dielectric member; and
- applying a potential difference between first and second electrodes thereby applying a potential difference across said dielectric member to generate a clamping force on said substrate,

characterized in that said first dielectric member is made of a material which has a specific resistivity of at least $10^{16}$ $\Omega$cm and a coefficient of thermal expansion of less than $0.02 \times 10^{-6} K^{-1}$.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and extreme ultra-violet (EUV) radiation (*e.g.* having a wavelength in the range 5-20 nm), as well as particle beams, such as ion beams or electron beams.

Embodiments of the invention will now be described, by way of example only, with reference to the accompanying schematic drawings in which:

Figure 1 depicts a lithographic projection apparatus according to an embodiment of the invention;
Figure 2 depicts an electrostatic chuck of the first embodiment of the present invention;
Figure 3 illustrates an electrostatic chuck of the second embodiment of the present invention;
Figure 4 illustrates a third embodiment of electrostatic chuck according to the present invention;
Figure 5 illustrates a fourth embodiment of electrostatic chuck according to the present invention; and
Figure 6 illustrates the method of joining a glass member to a glass ceramics member with an electrode sandwiched therebetween.

In the Figures, corresponding reference symbols indicate corresponding parts.

Embodiment 1

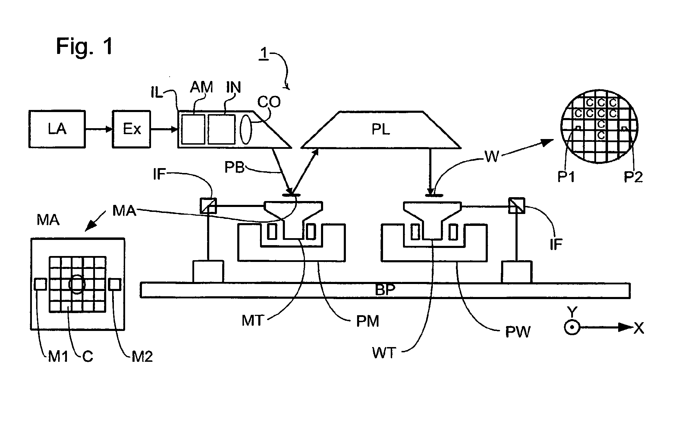

Figure 1 schematically depicts a lithographic projection apparatus according to a particular embodiment of the invention. The apparatus comprises:

· a radiation system Ex, IL, for supplying a projection beam PB of radiation (*e.g.* EUV radiation), which in this particular case also comprises a radiation source LA;
· a first object table (mask table) MT provided with a mask holder for holding a mask MA (*e.g.* a reticle), and connected to first positioning means for accurately positioning the mask with respect to item PL;
· a second object table (substrate table) WT provided with a substrate holder for holding a substrate W (*e.g.* a resist-coated silicon wafer), and connected to second positioning means for accurately positioning the substrate with respect to item PL;
· a projection system ("lens") PL (*e.g.* a mirror system) for imaging an irradiated portion of the mask MA onto a target portion C (*e.g.* comprising one or more dies) of the substrate W.

As here depicted, the apparatus is of a reflective type (*i.e.* has a reflective mask). However, in general, it may also be of a transmissive type, for example (with a transmissive mask). Alternatively, the apparatus may employ another kind of patterning means, such as a programmable mirror array of a type as referred to above.

The source LA (*e.g.* a laser produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed $v$, so that the projection beam PB is caused to scan over a mask image; concurrently, the substrate table WT is simultaneously moved in the same or opposite direction at a speed $V = Mv$, in which $M$ is the magnification of the lens PL (typically, *M* = 1/4 or 1/5). In this manner, a relatively large target portion C can be exposed, without having to compromise on resolution.

Where the radiation of the projection beam is strongly absorbed or scattered by ambient air, as is the case with EUV, X-rays, electrons and ions, the beam path, or at least critical parts of it, must be kept in vacuum. This can be achieved by providing a single vacuum chamber enclosing the complete apparatus or by providing separate, interconnected, vacuum chambers for the necessary components, e.g. radiation system, patterning means, projection system and substrate table.

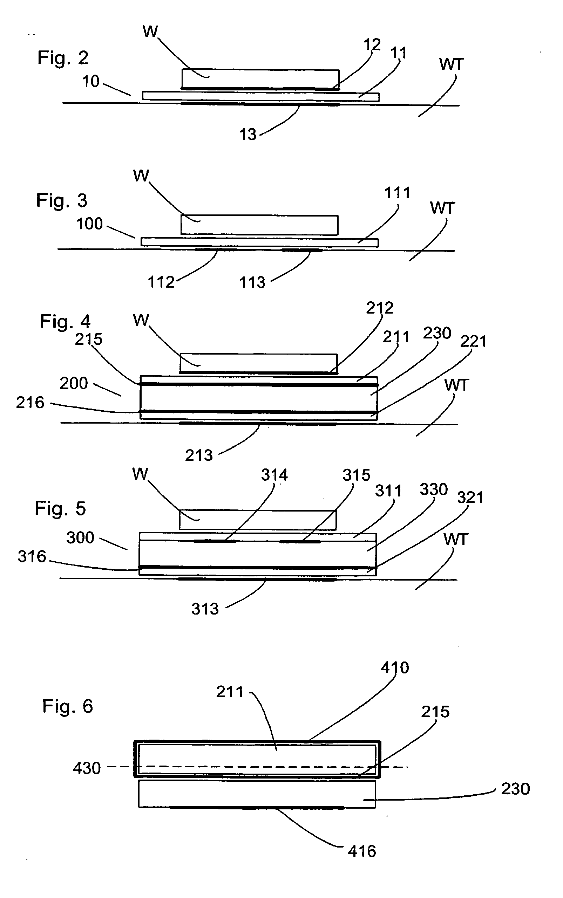

Figure 2 of the application shows a chuck 10 used in the first embodiment of the invention to hold the substrates W onto the substrate table WT. The chuck 10 comprises a member 11 made of a dielectric material. The dielectric member 11 is planar and is polished on either side to the required flatness e.g. requiring no deviations from a perfect plane of greater than, for instance, 200 nm or even higher specification, dependent on the specific application. The dielectric member should have a near zero coefficient of thermal expansion (i.e. less than $0.02 \times 10^{-6} K^{-1}$ (relative expansion/contraction per unit temperature)) so that the position of the substrate in the apparatus when held on the chuck is not sensitive to temperature fluctuations in the apparatus.

The first embodiment shows the most basic form of chuck for an easy understanding of the present invention. In this embodiment an electrode 13 is positioned in or on the substrate table WT and another electrode 12 is positioned on the bottom surface of the substrate W which is to come into contact with a first side of the dielectric member 11. If the substrate W is made of a conductive or semi-conductive material, the electrode 12 is not required. In use, the chuck 10 is placed on a suitably prepared surface of the substrate table WT. If the substrate table WT is made of a non-conducting material, this surface can have applied thereto a suitable electrode 13. The substrate W is then placed on top of the chuck 10. To hold the substrate W in place, a power supply is used to apply a potential difference V, between the electrode 12 of the substrate W and electrode 13 of the substrate table WT. The electrode 12 of the substrate W and electrode 13 will act as a capacitor and accordingly will experience an attractive force when the potential differences are applied between them. This force, F, is given by:

$$\frac{F}{A} = \frac{\varepsilon_0}{2} \times \left( \frac{\varepsilon_r . V}{(\varepsilon_r . g + d)} \right)^2 \qquad (1)$$

where A is the area of the effective capacitor, d the thickness of the dielectric layer between the electrodes, $\varepsilon_r$ the relative permittivity of the dielectric and g the thickness of any air gaps that will inevitably be present between the conducting surfaces of the clamp 10 and the substrate W and substrate table WT. This equation can be derived by regarding the air gap and the dielectric material as capacitors in series. The dielectric member preferably has as thickness of between 5 and 500 $\mu$m, preferably in the region of about 100 $\mu$m.

Because the first surface of dielectric member 11 has a certain surface roughness, the wafer does not make contact over the entire surface but only with a small portion of the atoms at the surface. Because only a small amount of the surface makes contact there is a surface resistance across the interface. This results in a potential drop across the interface. If a small current, I, is allowed to flow in the dielectric material, this small potential difference gives rise to the build up of opposite charges in the area of the interface where there is no contact. These opposite charges will attract one another providing a further clamping force due to the Johnson-Rahbek effect, which can be quite large because of the small distances of the air gap, of the order of 10nm.

The force associated with the Johnson-Rahbek effect increases with time that the potential difference is applied. When the potential difference is removed from the electrodes a residual force will gradually decrease with time. This can be awkward in a lithographic projection apparatus as the electrostatic clamp cannot be turned on and off instantaneously to hold the substrate W or allow it to be removed, if the force of the Johnson-Rahbek effect is too great. If the Johnson-Rahbek force is allowed to increase too much, either by allowing a too high a current leakage through the dielectric member 11 or by applying the potential difference between electrodes for a long time, then this can adversely effect the productivity of the lithographic projection apparatus; when removing the substrate W from the substrate table WT it is necessary to wait for the Johnson-Rahbek force to decrease to a level at which the substrate may be removed from the electrostatic chuck.

It has been found that by ensuring that the specific resistivity of the dielectric material is at least $10^{16}$ $\Omega$cm, the Johnson-Rahbek force never reaches high enough levels to detrimentally effect the productivity of the lithographic apparatus for typical lengths of time of holding a substrate W as the clamping force falls to a predetermined level quickly. Unfortunately few materials with near zero coefficient of thermal expansion (i.e. less than $0.02 \times 10^{-6} K^{-1}$) have such a high specific resistivity.

A specific RC time JR clamping can be calculated based on an estimated interface capacity and resistance. This RC time is very dependent on the specific volume resistivity of the dielectric material. The build up and removal of JR forces is governed by the RC time for JR clamping. It is therefore important to chose the resistance of the dielectric material such that or a very short RC time is created (0.1 s) or a very long one (several days).

In the first case a JR clamp is created with strong forces and in the second case a capacitive/coulombic clamp where the JR forces as much as possible absent. A value of specific resistivity of more than $10^{16}$ $\Omega$cm creates for a 10 $\mu$m thick dielectric material an RC time of several hours, while the resistivity of ULE (TM) at room temperature creates an RC time of several days.

Preferably the specific resistivity of the dielectric member is at least $10^{17}$ $\Omega$cm. The material of the dielectric member is preferably also one which has good optical/mechanical properties, in that it can be polished to a high flatness and one which preferably has a very low coefficient of thermal expansion i.e. even as low as 0.015 x $10^{-6}K^{-1}$ or 0.01 x $10^{-6}K^{-1}$. ULE (TM), a glass manufactured by Corning Incorporated, One River Front Plaza, Corning, NY 14831 has been found to meet all of the criteria. This is a material based on $SiO_2$ with $TiO_2$ present in a quantity of about 7wt%. Other low expansion materials (including glasses and glass ceramics which are a combination of a glass and a ceramic material; they are neither a glass or a ceramic material) may also be suitable. Suitable glass ceramics might be based on $SiO_2$ and at least one alkaline metal oxide such as $Na_2O$, $Li_2O$ or $K_2O$.

It has been found that whilst ULE (TM) produces satisfactory results in terms of limiting the force due to the Johnson - Rahbek effect, Zerodur ($SiO_2$ with 2.5% Li and 0.5% Na), with a specific resistivity of $3.10^{13}$ $\Omega$cm does not produce satisfactory results and neither does Clearceram (Li doping only) available from Clearceram-Z of OHARA inc. 15-30 Oyama 1-chome, Sagamihara-Shi, Kanagawa, 229-1186, Japan, which has a specific resistivity of $5.10^{12}$ $\Omega$cm.

ULE (TM) has a specific resistivity of about $10^{18}$ $\Omega$cm and a coefficient of thermal expansion of less than 0.01 x $10^{-6}K^{-1}$. However, other materials may also be used as the dielectric member 11 of the electrostatic chuck 10 as long as the specific resistivity is below $10^{16}$ $\Omega$cm. Glass ceramics are a promising class of materials in this regard.

To minimize the stray fields in the apparatus, which is particularly desirable where charged particles are used as the projection beam radiation, the substrate W and electrode 12 on the back of the substrate W can be grounded and the electrode 13 on the substrate table WT charged to a different potential.

It should also be noted that the chuck 10 of the present invention may also be used to clamp masks MA to a mask table MT. For reflective masks, the clamp can have the same shape as the mask, e.g. square, rectangular or round, whereas for a transmissive mask, the chuck of the invention may have the form of a frame with a central opening corresponding to the pattern area.

The chuck 10 of the first embodiment may be permanently attached to the substrate table WT. In fact, the chuck 10 of the first embodiment may not be particularly practical if the chuck 10 is separate from the substrate table WT. This is because when the potential difference between electrodes 12 and 13 is removed, as well as the substrate W being removable from the chuck 10, the chuck 10 is removable from the substrate table WT. That is, there is no separate control for releasing one without the other.

In an alternative embodiment (not illustrated), a further electrode may be embedded in the dielectric member 11 such that a voltage difference between that embedded electrode and the electrode 13 in the substrate table WT can be used to control the attachment of the electrostatic chuck to the substrate table WT and the potential difference between the embedded electrode in the dielectric member 11 and the electrode 12 attached to the bottom of the substrate W can be used to control the clamping force between the electrostatic chuck 10 and the substrate W.

Three more embodiments of chuck are described below which have various advantages over the chuck of the first embodiment which will become obvious from the related descriptions.

The chuck 100 of the second embodiment of the present invention (which is a bipolar or multipolar chuck), illustrated in Figure 3, comprises a dielectric member 111 which is attached to the substrate table WT. Sandwiched between the dielectric member 111 and the substrate table WT are two electrodes 112, 113 which are in the same plane but are separate (i.e. in spaced apart relationship) from one another. In this way, the substrate W does not require an electrode or electrical contact to be applied to its bottom surface as it does not need to be connected to ground or a high voltage supply. Instead, by applying potential difference between the first electrode 112 and the second electrode 113 the substrate W may be held to the dielectric element 111. The requirements of the dielectric element 111 are the same for the second embodiment as they are for the first embodiment.

The chuck 200 of the third embodiment is illustrated in Figure 4. The electrostatic element of the third embodiment is separate from the substrate table WT. The chuck 200 comprises a core 230 either side of which is attached a (first or second) dielectric member 211, 221 with a first or second electrode 215, 216 sandwiched between the core 230 and each of the dielectric members 211, 221. In this way, a potential difference between the second electrode 216 sandwiched between the core 230 and the second dielectric member 221 and an electrode 213 in or on the substrate table WT can be applied to hold the chuck 200 to the substrate table WT. A potential difference applied between the first electrode 215 of the chuck 200 and an electrode 212 applied to the bottom of the wafer W can be used to hold the wafer to the chuck 200. In the third embodiment the dielectric members 211, 221 need the same physical properties as the dielectric members of the first and second embodiments. The core 230 is preferably made of a near zero thermal expansion material such as Zerodur (TM) (which is manufactured by Schott Glas, Hattenbergstraße, 10 55120 Mainz, Germany) though any other glass ceramics with some conductivity may be used (e.g. Clearceram (TM)).

A fourth embodiment of the present invention is illustrated in Figure 5 and is a combination of the second and third embodiments. The chuck 300 of the fourth embodiment is comprised of first and second dielectric members 311, 321 and a core 330 as in the third embodiment of the present invention. The electrode 313 in the substrate table WT and the electrode 316 at the bottom of the chuck 300 are the same as for the third embodiment. However, a first and second electrode 314, 315 are sandwiched between the core 330 and first (the top as illustrated) dielectric member 311 of the chuck 300. The first and second electrodes 314, 315 are in the same plane but are separate from each other and their functioning to provide a force on the substrate W is the same as in the first and second electrodes 112 and 113 of the second embodiment. The fourth embodiment has the advantages of a separate chuck (e.g. for cleaning) and also of not requiring a grounding connection to the bottom surface of the substrate W.

The first (upper as illustrated) surface of the first dielectric member 11, 111, 211, 311 of the chuck onto which the substrate W is placed may be provided with burls (or pimples). The burls have a total surface area that is a small fraction of the total surface area of the substrate W so that there is a high probability that any contaminant particle that adheres to the substrate W or to the electrostatic chuck will lie between the burls. In that case, the contaminant particle will not cause a deformation of the substrate W unless it is larger than the width of the gap by which the burls raise the substrate W above the electrostatic chuck. Even if a contaminant particle is larger than the gap, its effect is reduced.

As described above, some embodiments of electrostatic chuck require bonding between the dielectric member 111, 211, 311, 221, 321 and the substrate table WT or the core 230, 330. Each of those components is preferably made of a low coefficient of thermal expansion material. Such materials are often glass like and can be difficult to join together accurately without deformation.

In the chuck of the present invention it is necessary to provide an electrode between the dielectric element 111, 211, 221, 311, 321 and the substrate table WT or core 230, 330. It is possible to make such a bond with the high degree of accuracy required and without introducing further materials such as glue or solder and which also produces a very strong molecular/chemical bond as described below.

The method of joining a glass ceramic element and a glass element will be described with reference to Figure 6. The method will be described with reference to joining ULE (TM) and Zerodur (TM) with an aluminium layer of about 300 nm thickness between the two elements. The process may be used to join other types of glass and/or glass ceramics with different thickness and metal layer material.

The method is described in relation to the production of a chuck according to the third embodiment of the present invention illustrated in Figure 4. It should be noted that the method is equally applicable to manufacturing substrate, mirror or mask tables for a lithographic projection apparatus. For the chuck of the third embodiment, the final thickness of the various layers are 100 $\mu$m for the dielectric members 211, 221, 300 nm for the 2 electrodes 215, 216 which are made of aluminium and about 2 mm of Zerodur (TM) as the core 230. With these dimensions the aluminium electrode 215, 216 is too thin to have an influence on the near zero thermal expansion characteristics of the entire chuck 200.

The first step is to polish the blocks of ULE (TM) 211 to the required degree of surface finish. The actual thickness of the block is unimportant because, as will be described later, the block of dielectric member 211 is ground to the correct thickness as a final step. Once the dielectric member 211 has been polished to a satisfactory finish, it is coated with an aluminium coating 410 with a thickness of about 300 nm. The coating has been illustrated as covering the whole surface of the dielectric member 211. Of course, this is not necessary and only the interface surface need be coated. One way of coating the aluminium on the ULE is by vapour deposition though other methods, such as spraying or immersing are also possible. Of course other metals than aluminium may also be used. Also more than one layer for e.g. a stronger metal coating, may be used.

The next step is for the core 230 to be polished. In the embodiment the core is made of Zerodur (TM) or Clearceram (TM), i.e. materials which are capable of being anodically bonded and which have the required low thermal expansion characteristics.

The block of coated dielectric material 211 is then brought into contact with a surface of the core 230 to which the dielectric material is to be attached. On the side of the core 230 opposite to the dielectric member 211 an electrode must be attached. This is most easily achieved by using silver paint 416 on the surface of the Zerodur glass ceramic. The assembly is then heated to about 300°C though the temperature may be as low as 150°C at the expense of longer bonding time or as high as 350°C. The exact temperature is chosen according to the material and its thickness - see below.

Once the assembly has reached 300°C a potential difference is applied between the coating 410 on the dielectric element 211 and the silver paint 416 on the other side of the core 230. The coating 410 is used as the anode and the silver paint 416 is used as the cathode. The temperature is chosen so that a current of at least 0.01 mA/cm$^2$ is allowed to flow in the material. For Zerodur (TM) this means between 275 to 300 °C depending on the thickness.

Zerodur (TM) contains about 2.5 weight percent Li$^+$ ions and 0.5 weight percent Na$^+$ ions, both are alkaline metals and both take part in the ion current in the Zerodur (TM) in this method. The other low expansion material ULE (TM), has no alkaline ions but is comprised of $SiO_2$ doped with about 7 weight percent of $TiO_2$. Thus, the specific resistivity of ULE (TM) is about 5 orders lower than Zerodur (TM), $10^{18}$ Ωcm as compared to $10^{13}$ Ωcm (at room temperature).

Thus, on application of the potential across the Zerodur (TM), the positively charged Li and Na ions are attracted towards the side of the core 230 closest to the negative electrode 416. This has the effect of depleting positive alkali atoms from the interface of the core 230 and the coating 410 of the dielectric member 212. A negative charge density in the form of $O^{2-}$ ions is formed at the interface between the core 230 and the coating 410. This induces charges in the Al and the Al is oxidized to $Al^{3+}$ ($Al \rightarrow Al^{3+} + 3e^-$) in the coating 410 and a very strong electrostatic attractive force is formed between the core 230 and the coating 410. The electrostatic force/pressure obtained with 150 volts is above 10 bar with a 1 μm gap. In reality the gap is likely to be smaller than this and the voltages also larger so a larger pressure than 10 bar is to be expected. The large force presses the two materials at the interface together and a molecular contact between the material of the core 230 and the material of the coating 410 is created.

With the aluminium in contact with the negatively charged layer of Zerodur (TM), there is a driving force for the $Al^{3+}$ to move toward the Zerodur (TM) and the $O^{2-}$ to move towards the Al coating and a bonding layer between the metal of the coating 410 and the Zerodur (TM) is created. It is thought that, in the crystal structure of the Zerodur (TM) of the core 230, the aluminium replaces the alkali ions which have migrated towards the painted silver electrode 416.

After the potential difference between the electrodes has been removed, the assembly must be cooled at a rate of at most 0.1 K/min for the Zerodur (TM) to maintain the low coefficients of thermal expansion.

Once cooled, the ULE (TM) dielectric member 211 and indeed the Zerodur (TM) core 230 may be machined to the correct dimensions.

The method of bonding described above is most successful if the current in the core is at least 0.01 mA/cm$^2$. 0.01 mA/cm$^2$ for 1000 seconds or 5000 seconds leads to a charge accumulated of 10mC/cm$^2$ (for a minimum bond) to 50mC/cm$^2$ (for a standard bond) respectively. A charge of 10mC/cm$^2$ leads to about 14 atomic layers of the Al layer being oxidized to $Al^{3+}$.

Table 1 illustrates the conditions of three experiments which resulted in successful bonds between a aluminium layer and a block of Zerodur (TM). The important factors are the temperature (higher temperature leads to a quicker bonding process), the voltage applied (a higher voltage leads to a larger current and thus less time for bonding to take place) and of course the time of application of potential difference which determines the amount of alkali depletion and amount of aluminium oxidation and thus bond formation. Also important are the surface quality of the core 230 and the coating 410 and the linear expansion coefficients, thickness of the aluminium layer and type of metal are also import

TABLE 1

| Experiment No. | Thickness of Al (μm) | Temperature (°C) | Voltage applied (V) | Time (Minutes) | Current (mA) |
|---|---|---|---|---|---|
| 1 | Several mm | 250 | 1000 | 15 | 1.08 at first decreasing to 0.12 |
| 2 | Several mm | 250 | 2000 increased in 100 volt steps | 50 | Final current = 0.3 mA |
| 3 | 300 nm | 275 | 1500 increased in 200 volt steps | 40 | Final current = 0.2 mA |

In all three experiments, a sufficiently strong bond between the aluminium and the Zerodur was created. In experiment 3 the aluminium had been coated on a block of ULE (TM) as described above. Sample 3 had the layer of ULE (TM) ground away to reduce its thickness. The ULE (TM) was successfully thinned to a thickness of 200 μm.

In another example, instead of painting a silver electrode 416 on the core 230, a second dielectric member 221 also coated in aluminium 420 may be placed on the side of the core 230 opposite the first dielectric member 212. Thus, the coating 420 on the second dielectric element 221 is used as the second electrode in the process in which AC is used.

This method of bonding (anodic bonding) can be used to bond glass or glass ceramic members together and is particularly suited to manufacture of substrate, mirror or mask tables or frames for lithographic projection apparatus and other optical applications such as space applications where the low coefficient of thermal expansion properties of glass ceramics (particularly materials like Zerodur (TM)) are particularly advantageous. In particular complex shapes can be build up from a plurality of Zerodur (TM) members with Al layers. This allows complex frames which are lighter and stiffer than is possible to machine out of a single block to be made with is particularly advantageous in the space industry and in optical applications in general.

Other methods are also suitable for manufacturing the chuck and in particular joining dielectric layers to the core. One method is simply gluing.

In another method of joining, after polishing (e.g. by plasma cleaning), the Zerodur (TM) is coated with a thin layer of Cr to a thickness of 20-50 nm. Optionally a SiO$_2$ layer is coated onto the Cr layer before the ULE (TM) is physically bonded onto the outer layer (Cr or SiO$_2$) using wringing (aanspringen in Dutch).

Whilst specific embodiments of the invention have been described above, it will be appreciated that the invention may be practiced otherwise than as described. The description is not intended to limit the invention.

**Claims**

1.  A chuck (10, 100, 200, 300) for use in holding onto a supporting table (WT, MT) by electrostatic force:

    - a substrate (W) to be processed in manufacturing devices employing lithographic projection techniques; or
    - a lithographic projection mask (MA) or mask blank in a lithographic projection apparatus, a mask handling apparatus such as a mask inspection or cleaning apparatus, or a mask manufacturing apparatus;
    said chuck comprising:

    a first dielectric member (11, 111, 211, 221, 311, 321), **characterized in that** said first dielectric member is made of a material which has a specific resistivity of at least 10$^{16}$ Ωcm and a coefficient of thermal expansion of less than 0.02 x 10$^{-6}$K$^{-1}$.

2.  A chuck (10, 100, 200, 300) according to claim 1, wherein said specific resistivity of the material of the first dielectric member (11, 111, 211, 221, 311, 321) is at least 10$^{17}$ Ω cm.

3.  A chuck (10, 100, 200, 300) according to claim 1 or 2, wherein the first dielectric member (11, 111, 211, 221, 311, 321) has a thickness of between 5 and 500 μm.

4.  A chuck (10, 100, 200, 300) according to claim 1, 2 or 3, wherein the first dielectric member (11, 111, 211, 221, 311, 321) is made of a material comprising SiO$_2$ containing TiO$_2$ in a quantity of less than 10 wt%.

5.  A chuck (10, 100, 200, 300) according to any one of claims 1 to 4, wherein said first dielectric member (11, 111, 211, 221, 311, 321) is made of ULE (TM).

6.  A chuck (10, 100, 200, 300) according to any one of claims 1 to 5, wherein a first electrode (12, 112, 113, 215, 216, 314, 315, 316) is provided on a first surface of said first dielectric member (11, 111, 211, 221, 311, 321).

7.  A chuck (10, 100, 200, 300) according to any one of claims 1 to 5, wherein a first electrode (112, 314) and a second electrode (113, 315) are provided on a first surface of said first dielectric member (11, 111, 211, 221, 311, 321) in spaced apart relationship.

8.  A chuck (10, 100, 200, 300) according to claim 6 or 7, wherein said chuck further comprises a core (230, 330) attached to said first side of said first dielectric member (211, 311); a second dielectric member (221, 321) being attached to said core (230, 330) on a side opposite said first dielectric member (211.311) and with a third electrode (216, 316) sandwiched between said core (230, 330) and said second dielectric member (221, 321).

9.  A chuck (10, 100, 200, 300) according to claim 8, wherein said core (230, 330) is made of Zerodur (TM) or Clearceram (TM).

10. A chuck (10, 100, 200, 300) according to any one of claims 1 to 9, wherein said first and/or second dielectric member (211, 311, 221, 321) is joined to said core (230, 330) by ion exchange between said core and said first or third electrode effected by application of a potential difference between said first and third electrodes.

11. A chuck (10, 100, 200, 300) according to claim 10, wherein said first and/or second dielectric member (211, 311, 221, 321) was coated with metal before being joined to said core, said metal forming said first or third electrode.

12. A chuck (10, 100, 200, 300) according to claim 10 or 11, wherein said first and/or second dielectric member (211, 311, 221, 321) was joined to said core at between 150-350°C.

13. A chuck (10, 100, 200, 300) according to any preceding claim, wherein said chuck is arranged for applying a potential difference across said first dielectric member (211, 311).

14. A lithographic projection apparatus (1) comprising:

- a radiation system (LA, EX, IL) for providing a projection beam (PB) of radiation;
- a support structure (MT) for supporting patterning means (MA), the patterning means serving to pattern the projection beam according to a desired pattern;
- a substrate table (WT) for holding a substrate (W);
- a projection system (PL) for projecting the patterned beam onto a target portion of the substrate,
- a chuck (10, 100, 200, 300) according to any one of the preceding claims on said support structure (MT) or said substrate table (WT); and the chuck comprising
- at least a first electrode (12, 112, 113, 215, 216, 314, 315) for applying a potential difference across said first dielectric member of said chuck thereby to generate a clamping force.

15. An apparatus according to claim 13, wherein said electrostatic chuck (10, 100, 200, 300) is separate from said substrate table (WT) or support structure (MT) and a further electrode (213, 313) is provided in or on said substrate table or support structure.

16. An apparatus according to claim 13, wherein said electrostatic chuck is part of said substrate table (WT) or support structure (MT).

17. A device manufacturing method comprising the steps of:

- providing a substrate (W) that is at least partially covered by a layer of radiation-sensitive material;
- providing a projection beam (PB) of radiation using a radiation system;
- using patterning means (MA) to endow the projection beam with a pattern in its cross-section;
- projecting the patterned beam of radiation onto a target portion of the layer of radiation-sensitive material,
- providing an electrostatic chuck (10, 100, 200, 300) for holding said substrate (W) to said substrate table (WT), said electrostatic chuck comprising a first dielectric member (11, 111, 211, 221, 311, 321);
- positioning said substrate (W) on a first surface of said first dielectric member (11, 111, 211, 221, 311, 321); and
- applying a potential difference between first and second electrodes (12, 13, 112, 113, 215, 212, 314, 315) thereby applying a potential difference across said dielectric member to generate a clamping force on said substrate,

**characterized in that** said first dielectric member is made of a material which has a specific resistivity of at least $10^{16}$ $\Omega$ cm and a coefficient of thermal expansion of less than 0.02 x $10^{-6}K^{-1}$.

**Patentansprüche**

1. Eine Aufspannvorrichtung (10, 100, 200, 300) zur Verwendung beim Halten von Folgendem auf einem Stütztisch (WT, MT) durch elektrostatische Kraft:

- eines Substrats (W), das bei der Herstellung von Vorrichtungen unter Einsatz von lithographischen Projektionstechniken verarbeitet werden soll; oder
- einer lithographischen Projektionsmaske (MA) oder eines Maskenrohlings in einem lithographischen Projektionsgerät, einem Maskenhandhabungsgerät wie etwa einem Maskeninspektions- oder -reinigungsgerät oder einem Maskenherstellungsgerät;
wobei die Aufspannvorrichtung Folgendes beinhaltet:

ein erstes dielektrisches Element (11, 111, 211, 221, 311, 321), **dadurch gekennzeichnet, dass** das erste dielektrische Element aus einem Material gefertigt ist, das einen spezifischen Widerstand von mindestens $10^{16}$ $\Omega$cm und einen Wärmeausdehnungskoeffizienten von weniger als 0,02 x $10^{-6}$ $K^{-1}$ aufweist.

2. Aufspannvorrichtung (10, 100, 200, 300) gemäß Anspruch 1, wobei der spezifische Widerstand des Materials des ersten dielektrischen Elements (11, 111, 211, 221, 311, 321) mindestens $10^{17}$ $\Omega$cm beträgt.

3. Aufspannvorrichtung (10, 100, 200, 300) gemäß Anspruch 1 oder 2, wobei das erste dielektrische Element (11, 111, 211, 221, 311, 321) eine Dicke von zwischen 5 und 500 $\mu$m aufweist.

4. Aufspannvorrichtung (10, 100, 200, 300) gemäß Anspruch 1, 2 oder 3, wobei das erste dielektrische Element (11, 111, 211, 221, 311, 321) aus einem $SiO_2$ beinhaltenden Material gefertigt ist, das $TiO_2$ in einer Menge von weniger als 10 % Massenanteil enthält.

5. Aufspannvorrichtung (10, 100, 200, 300) gemäß einem der Ansprüche 1 bis 4, wobei das erste dielektrische Element (11, 111, 211, 221, 311, 321) aus ULE (TM) gefertigt ist.

6. Aufspannvorrichtung (10, 100, 200, 300) gemäß einem der Ansprüche 1 bis 5, wobei auf einer ersten Oberfläche des ersten dielektrischen Elements (11, 111, 211, 221, 311, 321) eine erste Elektrode (12, 112, 113, 215, 216, 314, 315, 316) bereitgestellt ist.

7. Aufspannvorrichtung (10, 100, 200, 300) gemäß einem der Ansprüche 1 bis 5, wobei auf einer ersten Oberfläche des ersten dielektrischen Elements (11, 111, 211, 221, 311, 321) eine erste Elektrode (112, 314) und eine zweite Elektrode (113, 315) in mit Abstand angeordneter Beziehung bereitgestellt sind.

8. Aufspannvorrichtung (10, 100, 200, 300) gemäß Anspruch 6 oder 7, wobei die Aufspannvorrichtung ferner einen Kern (230, 330) beinhaltet, der an der ersten Seite des ersten dielektrischen Elements (211, 311) angebracht ist; ein zweites dielektrisches Element (221, 321) an dem Kern (230, 330) auf einer dem ersten dielektrischen Element (211, 311) entgegengesetzten Seite angebracht ist, und wobei eine dritte Elektrode (216, 316) zwischen dem Kern (230, 330) und dem zweiten dielektrischen Element (221, 321) eingelegt ist.

9. Aufspannvorrichtung (10, 100, 200, 300) gemäß Anspruch 8, wobei der Kern (230, 330) aus Zerodur (TM) oder Clearceram (TM) gefertigt ist.

10. Aufspannvorrichtung (10, 100, 200, 300) gemäß einem der Ansprüche 1 bis 9, wobei das erste und/oder das zweite dielektrische Element (211, 311, 221, 321) durch Ionenaustausch zwischen dem Kern und der ersten oder dritten Elektrode, herbeigeführt durch die Anlegung einer Potenzialdifferenz zwischen der ersten und der dritten Elektrode, an den Kern (230, 330) gefügt ist.

11. Aufspannvorrichtung (10, 100, 200, 300) gemäß Anspruch 10, wobei das erste und/oder das zweite dielektrische Element (211, 311, 221, 321) mit Metall beschichtet wurde, bevor es an den Kern gefügt wurde, wobei das Metall die erste oder dritte Elektrode bildet.

12. Aufspannvorrichtung (10, 100, 200, 300) gemäß Anspruch 10 oder 11, wobei das erste und/oder das zweite dielektrische Element (211, 311, 221, 321) bei zwischen 150-350 °C an den Kern gefügt wurde.

13. Aufspannvorrichtung (10, 100, 200, 300) gemäß einem der vorhergehenden Ansprüche, wobei die Aufspannvorrichtung eingerichtet ist, um über das erste dielektrische Element (211, 311) eine Potenzialdifferenz anzulegen.

14. Ein lithographisches Projektionsgerät (1), das Folgendes beinhaltet:

  - ein Strahlungssystem (LA, EX, IL) zum Bereitstellen eines Projektionsstrahls (PB) aus Strahlung;
  - eine Stützstruktur (MT) zum Stützen eines Musteraufbringungsmittels (MA), wobei das Musteraufbringungsmittel dazu dient, den Projektionsstrahl gemäß einem gewünschten Muster zu mustern;
  - einen Substrattisch (WT) zum Halten eines Substrats (W);
  - ein Projektionssystem (PL) zum Projizieren des gemusterten Strahls auf einen Zielabschnitt des Substrats,
  - eine Aufspannvorrichtung (10, 100, 200, 300) gemäß einem der vorhergehenden Ansprüche auf der Stützstruktur (MT) oder dem Substrattisch (WT); und wobei die Aufspannvorrichtung Folgendes beinhaltet:
  - mindestens eine erste Elektrode (12, 112, 113, 215, 216, 314, 315, 316) zum Anlegen einer Potenzialdifferenz über das erste dielektrische Element der Aufspannvorrichtung, um dadurch eine Spannkraft zu erzeugen.

15. Gerät gemäß Anspruch 13, wobei die elektrostatische Aufspannvorrichtung (10, 100, 200, 300) von dem Substrattisch (WT) oder der Stützstruktur (MT) getrennt ist und in oder auf dem Substrattisch oder der Stützstruktur eine weitere Elektrode (213, 313) bereitgestellt ist.

**16.** Gerät gemäß Anspruch 13, wobei die elektrostatische Aufspannvorrichtung Teil des Substrattisches (WT) oder der Stützstruktur (MT) ist.

**17.** Ein Verfahren zum Herstellen einer Vorrichtung, das die folgenden Schritte beinhaltet:

- Bereitstellen eines Substrats (W), das mindestens teilweise mit einer Schicht aus strahlungsempfindlichem Material überzogen ist;
- Bereitstellen eines Projektionsstrahls (PB) aus Strahlung unter Verwendung eines Strahlungssystems;
- Verwenden eines Musteraufbringungsmittels (MA), um den Projektionsstrahl in seinem Querschnitt mit einem Muster zu versehen;
- Projizieren des gemusterten Strahls aus Strahlung auf einen Zielabschnitt der Schicht aus strahlungsempfindlichem Material;
- Bereitstellen einer elektrostatischen Aufspannvorrichtung (10, 100, 200, 300) zum Halten des Substrats (W) an dem Substrattisch (WT), wobei die elektrostatische Aufspannvorrichtung ein erstes dielektrisches Element (11, 111, 211, 221, 311, 321) beinhaltet;
- Positionieren des Substrats (W) auf einer ersten Oberfläche des ersten dielektrischen Elements (11, 111, 211, 221, 311, 321) und
- Anlegen einer Potenzialdifferenz zwischen der ersten und der zweiten Elektrode (12, 13, 112, 113, 215, 212, 314, 315), um dadurch eine Potenzialdifferenz über das dielektrische Element anzulegen, um eine Spannkraft auf das Substrat zu erzeugen,

**dadurch gekennzeichnet, dass** das erste dielektrische Element aus einem Material gefertigt ist, das einen spezifischen Widerstand von mindestens $10^{16}$ Ωcm und einen Wärmeausdehnungskoeffizienten von weniger als 0,02 x $10^{-6}$ $K^{-1}$ aufweist.

**Revendications**

**1.** Un mandrin (10, 100, 200, 300) destiné à être utilisé pour maintenir sur une table servant de support (WT, MT) grâce à une force électrostatique :

- un substrat (W) devant être traité dans des dispositifs de fabrication employant des techniques de projection lithographique ; ou
- un masque de projection lithographique (MA) ou une découpe de masque dans un appareil de projection lithographique, un appareil de manipulation de masque tel qu'un appareil d'inspection ou de nettoyage de masque, ou un appareil de fabrication de masque ;
ledit mandrin comprenant :

un premier élément diélectrique (11, 111, 211, 221, 311, 321), **caractérisé en ce que** ledit premier élément diélectrique est réalisé en un matériau qui a une résistivité spécifique d'au moins $10^{16}$ Ωm et un coefficient d'expansion thermique inférieur à 0,02 x $10^{-6}K^{-1}$.

**2.** Un mandrin (10, 100, 200, 300) selon la revendication 1, dans lequel ladite résistivité spécifique du matériau du premier élément diélectrique (11, 111, 211, 221, 311, 321) est d'au moins $10^{17}$ Ωcm.

**3.** Un mandrin (10, 100, 200, 300) selon la revendication 1 ou la revendication 2, dans lequel le premier élément diélectrique (11, 111, 211, 221, 311, 321) a une épaisseur comprise entre 5 et 500 μm.

**4.** Un mandrin (10, 100, 200, 300) selon la revendication 1, la revendication 2 ou la revendication 3, dans lequel le premier élément diélectrique (11, 111, 211, 221, 311, 321) est réalisé en un matériau comprenant du $SiO_2$ contenant du $TiO_2$ dans une quantité inférieure à 10 % en poids.

**5.** Un mandrin (10, 100, 200, 300) selon n'importe laquelle des revendications 1 à 4, dans lequel ledit premier élément diélectrique (11, 111, 211, 221, 311, 321) est réalisé en ULE (TM).

**6.** Un mandrin (10, 100, 200, 300) selon n'importe laquelle des revendications 1 à 5, dans lequel une première électrode (12, 112, 113, 215, 216, 314, 315, 316) est fournie sur une première surface dudit premier élément diélectrique (11, 111, 211, 221, 311, 321).

7. Un mandrin (10, 100, 200, 300) selon n'importe laquelle des revendications 1 à 5, dans lequel une première électrode (112, 314) et une deuxième électrode (113, 315) sont fournies sur une première surface dudit premier élément diélectrique (11, 111, 211, 221, 311, 321) dans une relation d'espacement l'une par rapport à l'autre.

8. Un mandrin (10, 100, 200, 300) selon la revendication 6 ou la revendication 7, dans lequel ledit mandrin comprend en outre une âme (230, 330) attachée audit premier côté dudit premier élément diélectrique (211, 311) ; un deuxième élément diélectrique (221, 321) étant attaché à ladite âme (230, 330) sur un côté opposé audit premier élément diélectrique (211, 311) et une troisième électrode (216, 316) étant prise en sandwich entre ladite âme (230, 330) et ledit deuxième élément diélectrique (221, 321).

9. Un mandrin (10, 100, 200, 300) selon la revendication 8, dans lequel ladite âme (230, 330) est réalisée en Zérodur (TM) ou Clearceram (TM).

10. Un mandrin (10, 100, 200, 300) selon n'importe laquelle des revendications 1 à 9, dans lequel ledit premier et / ou deuxième élément diélectrique (211, 311, 221, 321) est joint à ladite âme (230, 330) grâce à un échange d'ions entre ladite âme et ladite première ou troisième électrode effectué par l'application d'une différence de potentiel entre lesdites première et troisième électrodes.

11. Un mandrin (10, 100, 200, 300) selon la revendication 10, dans lequel ledit premier et / ou deuxième élément diélectrique (211, 311, 221, 321) a été enduit de métal avant d'être joint à ladite âme, ledit métal formant ladite première ou troisième électrode.

12. Un mandrin (10, 100, 200, 300) selon la revendication 10 ou la revendication 11, dans lequel ledit premier et / ou deuxième élément diélectrique (211, 311, 221, 321) a été joint à ladite âme à entre 150 et 350 °C.

13. Un mandrin (10, 100, 200, 300) selon n'importe quelle revendication précédente, dans lequel ledit mandrin est agencé pour appliquer une différence de potentiel aux bornes dudit premier élément diélectrique (211, 311).

14. Un appareil de projection lithographique (1) comprenant :

   - un système de rayonnement (LA, EX, IL) destiné à fournir un faisceau de projection (PB) de rayonnement ;
   - une structure formant support (MT) destinée à servir de support à un moyen pour conformer selon un motif (MA), le moyen pour conformer selon un motif servant à conformer le faisceau de projection selon un motif souhaité ;
   - une table porte-substrat (WT) destinée à porter un substrat (W) ;
   - un système de projection (PL) destiné à projeter le faisceau à motif sur une portion cible du substrat,
   - un mandrin (10, 100, 200, 300) selon n'importe laquelle des revendications précédentes sur ladite structure formant support (MT) ou ladite table porte-substrat (WT) ; et le mandrin comprenant
   - au moins une première électrode (12, 112, 113, 215, 216, 314, 315, 316) destinée à appliquer une différence de potentiel aux bornes dudit premier élément diélectrique dudit mandrin pour générer de ce fait une force de serrage.

15. Un appareil selon la revendication 13, dans lequel ledit mandrin électrostatique (10, 100, 200, 300) est distinct de ladite table porte-substrat (WT) ou structure formant support (MT) et une électrode supplémentaire (213, 313) est fournie dans ou sur ladite table porte-substrat ou structure formant support.

16. Un appareil selon la revendication 13, dans lequel ledit mandrin électrostatique fait partie de ladite table porte-substrat (WT) ou structure formant support (MT).

17. Un procédé de fabrication de dispositif comprenant les étapes de :

   - fournir un substrat (W) qui est au moins partiellement recouvert d'une couche de matériau sensible au rayonnement ;
   - fournir un faisceau de projection (PB) de rayonnement à l'aide d'un système de rayonnement ;
   - utiliser un moyen pour conformer selon un motif (MA) pour doter le faisceau de projection d'un motif dans sa coupe transversale ;
   - projeter le faisceau de rayonnement à motif sur une portion cible de la couche de matériau sensible au rayonnement,

- fournir un mandrin électrostatique (10, 100, 200, 300) pour maintenir ledit substrat (W) sur ladite table porte-substrat (WT), ledit mandrin électrostatique comprenant un premier élément diélectrique (11, 111, 211, 221, 311, 321) ;
- positionner ledit substrat (W) sur une première surface dudit premier élément diélectrique (11, 111, 211, 221, 311, 321) ; et
- appliquer une différence de potentiel entre les première et deuxième électrodes (12, 13, 112, 113, 215, 212, 314, 315) appliquant de ce fait une différence de potentiel aux bornes dudit élément diélectrique afin de générer une force de serrage sur ledit substrat,

**caractérisé en ce que** ledit premier élément diélectrique est réalisé en un matériau qui a une résistivité spécifique d'au moins $10^{16}$ Ωcm et un coefficient d'expansion thermique inférieur à 0,02 x $10^{-6}$K$^{-1}$.

## Fig. 1

Fig. 2

W

12  11

WT

10

13

Fig. 3

W

111

WT

100

112      113

Fig. 4

212

W

215      211  230  221

200

WT

216

213

Fig. 5

W

314    315    311  330  321

300

WT

316

313

Fig. 6

211      410

215

430

230

416

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 5296891 A
- US 5523193 A
- WO 9838597 A
- WO 9833096 A
- US 5229872 A
- US 6046792 A
- US 5969441 A
- WO 9840791 A
- EP 0947884 A
- US 20020044267 A
- US 5221403 A
- US 5835333 A
- US 5835334 A
- US 6368942 B

### Non-patent literature cited in the description

- Microchip Fabrication: A Practical Guide to Semiconductor Processing. McGraw Hill Publishing Co, 1997